# EUROPÄISCHE PATENTSCHRIFT

(11) **EP 1 863 329 B1**
(45) Veröffentlichungstag und Bekanntmachung des Hinweises auf die Patenterteilung: **29.07.2009**
(21) Anmeldenummer: 07010172.0
(22) Anmeldetag: 22.05.2007
(51) Int. Cl.: H05K 9/00, H02G 3/22

(54) **EMV-Abdichtung**
EMC insulation
Etanchéification électromagnétique

(30) Priorität: 01.06.2006 DE 102006025674
(43) Veröffentlichungstag der Anmeldung: 05.12.2007
(73) Patentinhaber: Fujitsu Siemens Computers GmbH, 80807 München (DE)
(72) Erfinder: Neukam, Wilhelm, 86399 Bobingen (DE)
(74) Vertreter: Epping - Hermann - Fischer

(56) Entgegenhaltungen:
- WO-A-03/034800
- DE-U1- 29 620 388
- US-A- 6 119 305
- US-A1- 2003 127 853
- US-B1- 6 320 122

## Beschreibung

Die Erfindung betrifft eine EMV-Abdichtung an einer Computergehäusewandung umfassend eine erste Schaumstoffstruktur mit einer elektrisch leitfähigen Oberfläche, wobei die Computergehäusewandung und die darauf angeordnete erste Schaumstoffstruktur zumindest eine Durchführungsöffnung für ein Element aufweist.

EMV-Abdichtungen der oben genannten Art finden im Wesentlichen Verwendung zur Abdichtung gegenüber elektromagnetischen Störungen bei elektronischen Geräten wie Computern, und sind dazu an Gehäusewandungen angeordnet, insbesondere an Gehäusewandungen mit einer oder mehreren Gehäusedurchführungsöffnungen. Solche Gehäusewandungen werden bei Computern als I/O-Shield bezeichnet. Dort finden solche EMV-Abdichtungen häufig Verwendung.

Die Druckschrift DE 10143418 C1 zeigt ein Material zur Abschirmung elektromagnetischer Strahlung zur elektrischen Kontaktierung von elektrisch leitenden Bauteilen. Dabei ist ein Material vorgesehen, dass durch einen flexiblen, vorzugsweise offenporigen Schaumkörper aus Kunststoff oder Gummi gebildet ist, welcher mit einer metallischen Oberflächenbeschichtung durchgängig versehen ist.

Weiter ist aus der Druckschrift DE 29620388 U1 ein abgeschirmtes Gehäuse für ein Verteilerfeld bekannt, bei dem ein für Öffnungen für die Kabel zur Abschirmung mit mindestens zwei elektrisch leitfähigen elastischen Schaumstofflippen um das eingeführte Kabel dick abschließend versehen sind.

Durch die Durchführungsöffnungen der Gehäusewandung sind Bedienelemente, Stecker, Steckkontakte, Kabel, und ähnliches geführt, die zur Bedienung des elektrischen oder elektronischen Gerätes erforderlich sind. Nach außen sind diese Elemente selbst häufig durch eine Abschirmungsmaßnahme gegen elektromagnetische Störungen geschützt. Die EMV-Abdichtung mit der elektrisch leitfähigen Oberfläche kontaktiert mittels dieser die Abschirmungsmaßnahmen der Elemente und verbindet so das Computergehäuse mit den Abschirmungsmaßnahmen elektrisch. Durch die dauerelastischen Eigenschaften der EMV-Abdichtung wird eine Kontaktbildung und Abdichtung an Stellen erreicht, an denen sonst direkt Metall mit Metall kontaktieren würde.

Computer sind elektronische Geräte, die in einem besonderen Maß gegen elektromagnetische Störungen abzudichten sind. Dies ist auch dadurch begründet, dass Computer in immer höheren Taktfrequenzen arbeiten, und damit die Anforderungen an die Abdichtungen gegen elektromagnetische Beeinflussung und Störungen ebenfalls angestiegen sind. Mit steigenden Taktfrequenzen sind die Wellenlängen der abzuschirmenden elektromagnetischen Störungen sehr kurz, so dass alleine eine EMV-Abdichtung mit leitfähiger Oberfläche nicht mehr ausreicht. Dennoch zufrieden stellende Abdichtungen gegen elektromagnetische Störungen zu erwirken ist deshalb von großem technischem und monetärem Aufwand begleitet.

Es ist demzufolge die Aufgabe der Erfindung, die Qualität der Abschirmung kostengünstig an die gestiegenen Anforderungen anzupassen.

Diese Aufgabe wird mit einer EMV-Abdichtung gemäß Patentanspruch 1 gelöst und in den folgenden untergeordneten Patentansprüchen 2 bis 7 in vorteilhafter Weise weitergebildet.

Dabei ist eine EMV-Abdichtung der Eingangs genannten Art als erste Schaumstoffstruktur vorgesehen, wobei eine zweite Schaumstoffstruktur, mit einem elektrisch leitfähigen Schaumstoffwerkstoff, an der Durchführungsöffnung angeordnet ist und die Durchführungsöffnung im Querschnitt so verringert, dass die zweite Schaumstoffstruktur an dem Element elastisch oder formschlüssig anliegt.

Diese Art der Abdichtung ist in vielerlei Hinsicht vorteilhaft. So ist der preislich höher liegende elektrisch leitfähige Schaumstoffwerkstoff nur für geringe Volumen notwendig, der preislich günstige Werkstoff eine Schaumstoffstruktur mit elektrisch leitfähiger Oberfläche wird über die große Fläche eingesetzt. Somit ist eine bessere Abdichtung gegen elektromagnetische Störungen erreicht ohne kostenintensive Werkstoffe in großen Mengen zu benötigen. Insbesondere bei Massenprodukten wie Computern ist dies vorteilhaft, denn durch die hohen Stückzahlen von produzierten Geräten ist das Einsparpotential auch bei kleinen Beträgen pro Gerät von beträchtlichem Ausmaß.

Im Folgenden ist die Erfindung unter Zuhilfenahme eines Ausführungsbeispiels und einer Figur näher erläutert.

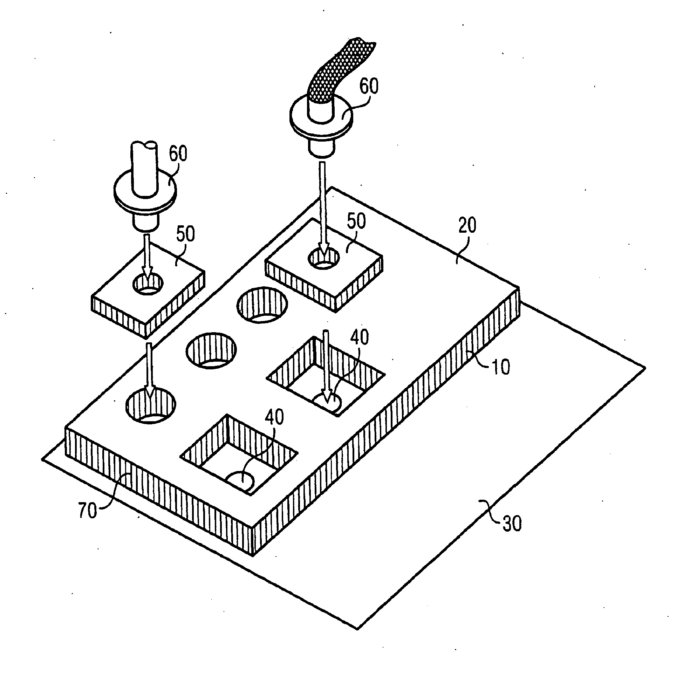

Es zeigt die Figur 1 eine EMV-Abdichtung mit erster und zweiter Schaumstoffstruktur.

Die EMV-Abdichtung besteht aus einer ersten Schaumstoffstruktur 10. Die erste Schaumstoffstruktur 10 weist eine elektrisch leitfähige Oberfläche 20 auf, ist flächig ausgebildet und ist an einer Computergehäusewandung 30 angeordnet. Die Computergehäusewandung 30 weist Durchführungsöffnungen 40 auf, welche zur Durchführung von Elementen 60 wie zum Beispiel Schaltern, Steckkontakten, Kabeln eingerichtet sind. Jedes der durchgeführten Elemente wird an der jeweiligen Durchführungsöffnung festgelegt. Dies erfolgt mit Schraubverbindungen oder Klemmverbindungen, so dass die EMV-Abdichtung durch das Element zusammengepresst wird. Somit erfolgt eine sichere Kontaktbildung zwischen den Elementen 60 und der EMV-Abdichtung.

Die Durchführungsöffnungen 40 können dazu verschiedene Formen und Abmessungen aufweisen. Die erste Schaumstoffstruktur 10 umfasst ebenfalls Durchführungsöffnungen 11, welche an die Durchführungsöffnungen 40 der Computergehäusewandung 30 angepasst sind. Die Durchführungsöffnungen 11 der ersten Schaumstoffstruktur 10 sind gegenüber den Durchführungsöffnungen 40 in der Computergehäusewandung 30 größer oder gleich, vorzugsweise aber größer, damit eine zweite Schaumstoffstruktur 50 einfügbar ist. Zur verbesserten Abdichtung gegen elektromagnetische Störungen ist gemäß dem Prinzip der Erfindung für jede Durchführungsöffnung 30 eine zweite Schaumstoffstruktur 50 vorgesehen, die so ausgebildet ist, dass sie an den Elementen 60 anliegt. Der Querschnitt der Durchführungsöffnungen 51 in der zweiten Schaumstoffstruktur bietet somit einen elektrischen Kontakt zu den Elementen 60, und bietet außerdem einen elektrischen Kontakt zu der elektrisch leitenden Oberfläche 20 der ersten Schaumstoffstruktur 10.

Eine vorteilhafte Ausführungsform der Erfindung sieht vor, die elektrische leitfähige Oberfläche 20 der ersten Schaumstoffstruktur 10 aus einem elektrisch leitfähigen Gewebe zu bilden. Eine elektrisch nicht leitende Schaumstoffstruktur mit einer elektrisch leitenden Oberfläche 20 ist günstiger in der Anschaffung als eine elektrisch leitende Schaumstoffstruktur. Eine an der Computergehäusewandung 30 angeordnete erste Schaumstoffstruktur 10 ist in ihrer flächigen Ausprägung so an der Computergehäusewandung 30 angeordnet, dass die elektrisch leitende Oberfläche 20 von der elektrisch leitenden Computergehäusewandung 30 beabstandet ist. Um eine elektrische Kontaktierung zur Computergehäusewandung 30 herzustellen ist die elektrisch leitende Oberfläche 20 über die äußeren Kanten 70 der ersten Schaumstoffstruktur 10 fortgesetzt. Somit ist eine gute Abschirmung gegenüber elektromagnetischen Störungen gegeben.

Die Querschnittsflächen der Aussparungen 51 der zweiten Schaumstoffstruktur 50 sind in ihrem Querschnitt etwas kleiner als die Durchführungsöffnungen 11 der ersten Schaumstoffstruktur 10 und insbesondere als die Durchführungsöffnungen 40 der Computergehäusewandung, aber im Besonderen kleiner als die Querschnittsflächen der Elemente 60, welche durch die Schaumstoffstrukturen geführt werden. Somit ist ein elektrischer Kontakt zwischen den Elementen und der zweiten Schaumstoffstruktur 50 verbessert.

Die zweite Schaumstoffstruktur 50 ist ebenfalls flächig ausgebildet, wobei sich zwei grundsätzliche Montageformen für die zweite Schaumstoffstruktur 50 anbieten. Die erste Montageform ist, die zweite Schaumstoffstruktur 50 in einer Ausnehmung der ersten Schaumstoffstruktur 10 formschlüssig einzufügen. Die zweite Montageform ist ein einfaches Darüberlegen der zweiten Schaumstoffstruktur 50 über die erste Schaumstoffstruktur 10. In beiden Fällen ergibt sich ein elektrischer Kontakt zwischen dem Element 60 und der Gehäusewandung 30, der über die erste Schaumstoffstruktur 10 und die zweite Schaumstoffstruktur 50 gebildet ist.

### Bezugszeichenliste

- 10: erste Schaumstoffstruktur
- 20: elektrisch leitfähige Oberfläche
- 30: Computergehäusewandung
- 40: Durchführungsöffnungen
- 50: zweite Schaumstoffstruktur
- 60: Element
- 70: Äußeren Kanten der ersten Schaumstoffstruktur

## Patentansprüche

1. EMV-Abdichtung an einer Computergehäusewandung mit einer Durchführungsöffnung (40) für ein Element (60), einer ersten Schaumstoffstruktur (10) mit einer elektrisch leitfähigen Oberfläche (20), die auf der Computergehäusewandung (30) angeordnet ist,
und eine Durchführungsöffnung (11) aufweist, die größer als die Durchführungsöffnung (40) in der Computergehäusewandung (30) ist,
einer zweiten Schaumstoffstruktur (50), mit
einem elektrisch leitfähigen Schaumstoffwerkstoff, die in die Durchführungsöffnung (11) der ersten Schaumstoffstruktur (10) formschlüssig einfügbar ist, und eine Durchführungsöffnung (51) in der zweiten Schaumstoffstruktur (50), die im Querschnitt so verringert ist, dass die zweite Schaumstoffstruktur (50) an dem Element (60) elastisch oder formschlüssig anliegt.

2. EMV-Abdichtung nach Patentanspruch 1
**dadurch gekennzeichnet, dass**
die erste Schaumstoffstruktur (10) elektrisch nichtleitend, dauerelastisch und flächig ausgebildet ist.

3. EMV-Abdichtung nach einem der vorhergehenden Patenansprüche,
**dadurch gekennzeichnet , dass**
die elektrisch leitfähige Oberfläche (20) aus einem elektrisch leitfähigen Gewebe gebildet ist.

4. EMV-Abdichtung nach einem der Patentansprüche 2 bis 3,
**dadurch gekennzeichnet, dass**
die flächig ausgebildete erste Schaumstoffstruktur (10) an der von der Computergehäusewandung (30) abgewandten Oberfläche die elektrisch leitende Oberfläche (20) aufweist, wobei über äußere Kanten (70) der ersten Schaumstoffstruktur (10) die leitfähige Oberfläche fortgesetzt ist, so dass ein elektrischer Kontakt mit der Computergehäusewandung (30) gebildet ist.

5. EMV-Abdichtung nach einem der vorhergehenden Patentansprüche
**dadurch gekennzeichnet, dass**
das Element (60) einen elektrischen Anschluss, ein Schaltelement oder ein Kabel umfasst.

6. EMV-Abdichtung nach einem der vorhergehenden Patentansprüche,
**dadurch gekennzeichnet, dass**
die zweite Schaumstoffstruktur (50) flächig ausgebildet ist.

7. EMV-Abdichtung nach einem der vorhergehenden Patentansprüche,
**dadurch gekennzeichnet, dass**
die zweite Schaumstoffstruktur (50) in einer Ausnehmung der ersten Schaumstoffstruktur (10) formschlüssig einfügbar ist.

## Claims

1. EMC sealing on a computer housing wall, having
a leadthrough opening (40) for an element (60),
a first foam structure (10) which has an electrically conductive surface (20), is arranged on the computer housing wall (30) and has a leadthrough opening (11) that is larger than the leadthrough opening (40) in the computer housing wall (30),
a second foam structure (50) which has an electrically conductive foam material and can be inserted into the leadthrough opening (11) of the first foam structure (10) in a form-fitting manner,
and a leadthrough opening (51) in the second foam structure (50), the cross section of said opening being reduced in such a manner that the second foam structure (50) rests on the element (60) in an elastic or form-fitting manner.

2. EMC sealing according to Patent Claim 1,
**characterized in that**
the first foam structure (10) is electrically nonconductive, permanently elastic and flat.

3. EMC sealing according to one of the preceding patent claims,
**characterized in that**
the electrically conductive surface (20) is formed from an electrically conductive woven fabric.

4. EMC sealing according to one of Patent Claims 2 to 3,
**characterized in that**
the flat first foam structure (10) has the electrically conductive surface (20) on the surface facing away from the computer housing wall (30), the conductive surface being continued over outer edges (70) of the first foam structure (10), with the result that electrical contact with the computer housing wall (30) is formed.

5. EMC sealing according to one of the preceding patent claims,
**characterized in that**
the element (60) comprises an electrical connection, a switching element or a cable.

6. EMC sealing according to one of the preceding patent claims,
**characterized in that**
the second foam structure (50) is flat.

7. EMC sealing according to one of the preceding patent claims,
**characterized in that**
the second foam structure (50) can be inserted in a recess of the first foam structure (10) in a form-fitting manner.

## Revendications

1. Etanchéification électromagnétique sur une paroi de châssis d'ordinateur comportant une ouverture traversante (40) destinée à un élément (60), une première structure en matière plastique mousse (10) comportant une surface électriquement conductrice (20), qui est disposée sur la paroi de châssis d'ordinateur (30), et présente une ouverture traversante (11), qui est plus grande que l'ouverture traversante (40) dans la paroi de châssis d'ordinateur (30), une deuxième structure en matière plastique mousse (50), comportant une matière mousse électriquement conductrice, qui peut être encastrée par conjonction de forme dans l'ouverture traversante (11) de la première structure en matière plastique mousse (10), et une ouverture traversante (51) dans la deuxième structure en matière plastique mousse (50), qui est rétrécie en coupe transversale de telle sorte que la deuxième structure en matière plastique mousse (50) vienne reposer sur l'élément (60) élastiquement ou par conjonction de forme.

2. Etanchéification électromagnétique selon la revendication 1,
**caractérisée en ce que**
la première structure en matière plastique mousse (10) a une configuration à plat, durablement élastique et électriquement non conductrice.

3. Etanchéification électromagnétique selon une des revendications précédentes,
**caractérisée en ce que**
la surface (20) électriquement conductrice est formée dans un tissu électriquement conducteur.

4. Etanchéification électromagnétique selon une des revendications 2 à 3,
**caractérisée en ce que**
la première structure en matière plastique mousse (10) configurée à plat présente sur la surface qui se détourne de la paroi de châssis d'ordinateur (30) la surface électriquement conductrice (20), moyennant quoi la surface conductrice est avancée sur les arêtes extérieures (70) de la première structure en matière plastique mousse (10), de telle sorte qu'un contact électrique avec la paroi du châssis d'ordinateur (30) soit formé.

5. Etanchéification électromagnétique selon une des revendications précédentes,
**caractérisée en ce que**
l'élément (60) comprend un raccord électrique, un élément de commutation ou un câble.

6. Etanchéification électromagnétique selon une des revendications précédentes,
**caractérisée en ce que**
la deuxième structure en matière plastique mousse (50) a une configuration à plat.

7. Etanchéification électromagnétique selon une des revendications précédentes,
**caractérisée en ce que**
la deuxième structure en matière plastique mousse (50) peut être encastrée par conjonction de forme dans un évidement de la première structure en matière plastique mousse (10).
